(19) Europäisches Patentamt
European Patent Office
Office européen des brevets

(11) **EP 2 873 952 A2**

(12) **DEMANDE DE BREVET EUROPEEN**

(43) Date de publication:
**20.05.2015 Bulletin 2015/21**

(51) Int Cl.:
*G01H 13/00* *(2006.01)* *B60C 23/04* *(2006.01)*

(21) Numéro de dépôt: **14193303.6**

(22) Date de dépôt: **14.11.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **18.11.2013 FR 1361246**

(71) Demandeur: **Senseor**
**06560 Valbonne (FR)**

(72) Inventeur: **Friedt, Jean-Michel**
**25000 BESANCON (FR)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(54) **Procédé d'interrogation rapide de dispositifs résonants à ondes élastiques**

(57) L'invention a pour objet un procédé d'interrogation d'un dispositif à ondes élastiques consistant à sonder la réponse d'un dispositif résonant, piézoélectrique, à une unique fréquence alternativement de part d'autre d'une première fréquence de résonance déterminée préalablement, pour caractériser cette fréquence de résonance caractéristique de la grandeur physique mesurée, en corrélant cette unique mesure avec une mesure précédente réalisée.

FIG.3

**Description**

Le domaine de l'invention est celui des dispositifs résonants à ondes élastiques interrogeables à distance et ce au travers d'une liaison sans fil radiofréquence. Ces dispositifs peuvent être utilisés notamment dans le cadre de capteurs.

De tels capteurs sont connus pour être utilisés par exemple comme capteur de température ou de pression et comprennent généralement au moins un résonateur comportant une micro-structure déposée à la surface d'un substrat piézoélectrique. Un exemple de capteur peut typiquement comporter deux transducteurs à peignes d'électrodes inter-digitées placés entre des réseaux réflecteurs. Les réseaux réflecteurs se comportent comme des miroirs et il existe donc des fréquences de résonance pour lesquelles le trajet retour dans la cavité est égal à un nombre entier de longueurs d'onde. Les modes de résonance pour ces fréquences sont excités par le transducteur placé entre les miroirs.

Ce type de capteur peut être interrogé à distance, en connectant l'entrée du transducteur à une antenne radio-fréquence RF. Lorsque l'antenne reçoit un signal électromagnétique, celui-ci donne naissance à des ondes sur la surface du substrat qui sont elles-mêmes reconverties en énergie électromagnétique sur l'antenne. Ainsi, le dispositif constitué d'un ensemble de résonateurs connecté à une antenne a une réponse aux fréquences de résonance des résonateurs qu'il est possible de mesurer à distance. On peut ainsi réaliser des capteurs interrogeables à distance. Cette possibilité est un avantage important des ondes acoustiques de surface et peut être utilisée notamment dans le cadre des capteurs de pression de pneumatiques. Il est en effet intéressant dans ce type d'application de pouvoir placer le capteur dans le pneumatique alors que l'électronique d'interrogation est embarquée à bord du véhicule.

Selon l'art connu, des systèmes d'interrogation à distance utilisent des signaux d'interrogation sous forme d'impulsions (typiquement de durée environ 25 $\mu$s) qui transitent via une antenne émettrice en direction d'une antenne réceptrice connectée au capteur à ondes de surface dénommé ci-après dans la description, capteur SAW.

Une bande de fréquences privilégiée pour ce type de systèmes est la bande ISM, acronyme anglo-saxon signifiant «Industriel, Scientific, Medical », ayant pour fréquence centrale la fréquence de 433,9 mégahertz et la largeur de bande associée de 1,7 mégahertz (MHz).

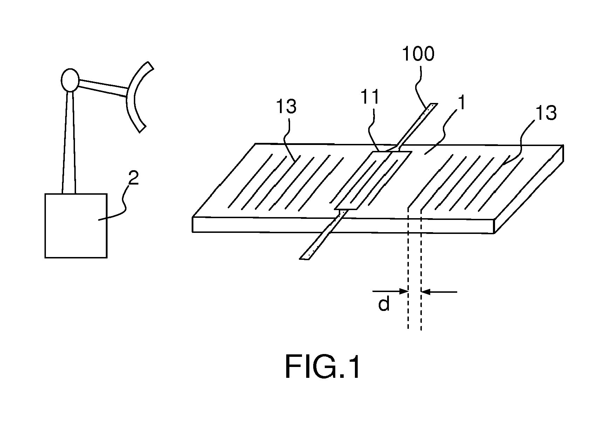

De manière générale un capteur SAW interrogeable à distance et son système d'interrogation peuvent comprendre, comme illustré en figure 1 dans le cas simplifié d'un seul transducteur :

- un système d'interrogation 2 ;
- au moins, un résonateur 1 comportant :

    o une antenne 100 ;
    o un transducteur à peigne d'électrodes inter-digitées 11 et une cavité résonante SAW 13 caractérisée par sa fréquence centrale F et son facteur de qualité Q, correspondant au rapport entre la fréquence centrale et la largeur de bande passante. La cavité 13 comprend deux séries de réflecteurs régulièrement espacés d'une distance d. Le transducteur est connecté à l'antenne 100.

L'interrogateur 2 envoie une impulsion radio-fréquence longue pour charger le résonateur 1. A l'arrêt de l'émission, le résonateur se décharge sur sa fréquence de résonance propre avec une constante de temps $\tau$ égale à $Q/(\pi F)$. Cette décharge du résonateur constitue l'écho en retour détecté par le récepteur de l'interrogateur. Une analyse spectrale permet ensuite de remonter à la fréquence du résonateur qui constitue son identification. Cette analyse peut être effectuée par des algorithmes basés sur la transformation de Fourier, par exemple de type FFT, acronyme anglo-saxon signifiant Fast Fourier Transform. Ce type de traitement par analyse spectrale est particulièrement complexe.

Une alternative à ce traitement complexe, a été précédemment démontré par le Demandeur, et consiste à sonder la réponse d'un dispositif résonant, piézoélectrique tant qu'il présente une variation abrupte de son coefficient de réflexion en fonction de la fréquence, à seulement 2 fréquences de part et d'autre de la fréquence de résonance pour caractériser cette fréquence de résonance caractéristique de la grandeur physique mesurée (Demande de brevet FR 2 958 417 et l'article de J.M Friedt, C. Droit, S. Ballandras, S. Alzuaga, G. Martin & P. Sandoz, Remote vibration measurement: a wireless passive surface acoustic wave resonator fast probing strategy, Rev. Sci. Instrum. 83, p.055001 (2012)).

Par rapport à cet art antérieur et pour perfectionner davantage ce type de procédé d'interrogation, le Demandeur a recherché à doubler la vitesse de rafraîchissement de l'information.

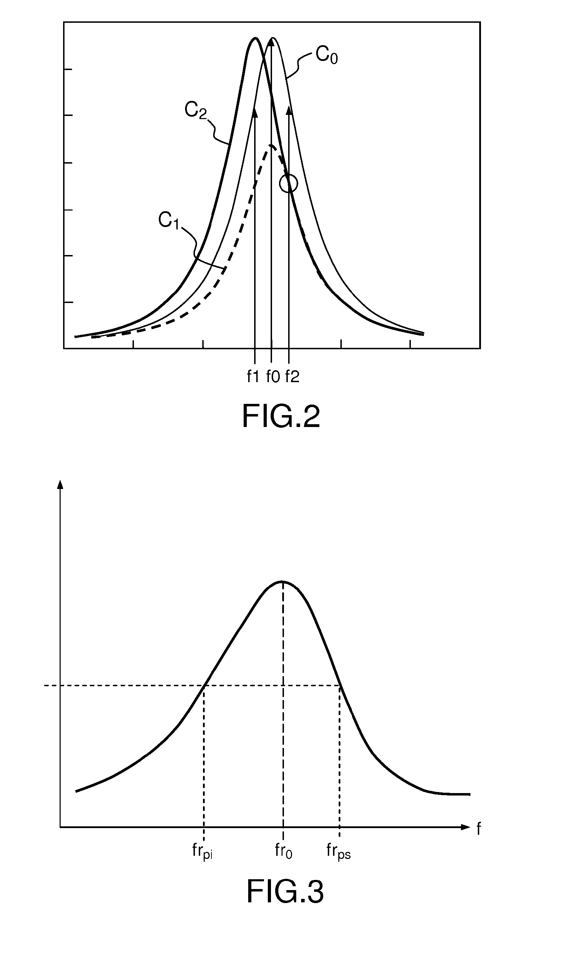

Cependant, pour cela, sonder sur un unique point de fonction de transfert est insuffisant comme l'illustre la figure 2. Cette figure met en évidence à partir de la courbe $C_0$ correspondant à une fonction de transfert initiale, les deux évolutions possibles à un instant ultérieur, à savoir : une atténuation du signal représentée par la courbe $C_1$ ou un décalage du signal de la fréquence de résonance représenté par la courbe $C_2$.

En effet, sur la figure 2, partant de la condition initiale de la fonction de transfert représentée par la courbe $C_0$ (fréquence de résonance f0, caractérisation aux deux fréquences f1 et f2), sonder la réponse à un instant ultérieur à une unique fréquence f2 ne permet pas de distinguer deux évolutions possibles de la fonction de transfert, à savoir une baisse de la puissance renvoyée par le capteur (réponse atténuée si le capteur s'éloigne de l'électronique de mesure) ou un décalage de la fréquence de résonance (correspondant à une variation de la grandeur physique). Ces deux conditions vont impliquer la même mesure, à savoir le cercle représenté.

Il n'est ainsi pas possible de séparer la contribution du bilan de liaison (le capteur s'approche ou s'éloigne du lecteur) de la grandeur physique mesurée (la fréquence de résonance se décale de la fréquence sondée).

Pour résoudre ce problème, le Demandeur propose un procédé d'interrogation, sondant un unique point de la fonction de transfert du dispositif résonant tantôt à la fréquence inférieure à la fréquence de résonance : fréquence f1, tantôt à la fréquence supérieure à la fréquence de résonance : fréquence f2.

La différence entre ces deux grandeurs permet d'asservir la puissance émise en vue d'optimiser la puissance radiofréquence reçue, tandis que l'hypothèse que le point précédent de mesure (sur ou sous la résonance) reste inchangé lors de la mesure complémentaire (sous ou sur la résonance) permet de doubler la fréquence d'échantillonnage d'identification de la fréquence de résonance du dispositif.

Cette condition respecte le théorème d'échantillonnage qui indique que l'on ne peut connaître l'évolution de la grandeur mesurée à la première fréquence au cours de la mesure sur la seconde fréquence : si le premier point venait à se décaler, il s'agirait d'une variation de la grandeur physique à une vitesse supérieure à la bande passante de la mesure, impliquant du repliement spectral.

Le fait de rafraîchir l'information d'estimation de la fréquence de résonance f0 après chaque mesure, tantôt à la fréquence f1, tantôt à la fréquence f2, n'handicape donc pas la précision de la mesure mais double la bande passante par rapport à une information rafraîchie après les deux mesures des réponses à la fréquence f1 et à la fréquence f2 tel que proposée dans la demande de brevet FR 2 958 417.

Plus précisément la présente invention a pour objet un procédé d'interrogation à distance d'un résonateur à ondes élastiques, permettant de déterminer la fréquence de résonance dudit résonateur présentant une courbe de résonance définie par conception dudit résonateur, caractérisé en ce qu'il comporte les étapes suivantes :

- une étape préalable de balayage en fréquence d'interrogation dudit résonateur dans une gamme de fréquences déterminée par conception dudit résonateur, permettant la détermination rapide d'une courbe de résonance centrée sur une fréquence de résonance préalable $fr_0$ comprise entre une fréquence préalable inférieure $fr_{pi}$ et une fréquence préalable supérieure $fr_{ps}$ définies à mi-hauteur de ladite courbe de résonance dudit résonateur, par détection de l'amplitude de signal de réponse dudit résonateur ;

- un premier ensemble d'étapes préalables comportant :

  o une première étape préalable d'un premier couple d'interrogations dudit résonateur à une première fréquence $f_{1,1}$ dite inférieure et à une deuxième fréquence $f_{2,1}$ dite supérieure telles que : $f_{1,1} = fr_0 - f_m/2$ et $f_{2,1} = fr_0 + f_m/2$, avec $f_m < fr_{ps} - fr_{pi}$, permettant de définir un premier couple d'amplitudes d'un premier signal et d'un second signal de réception $Pf_{1,1}$ et $Pf_{2,1}$ ;
  o une seconde étape préalable comportant la détermination de la différence des amplitudes des premier et second signaux $\Delta(Pf_{1,1}-Pf_{2,1})$, ladite différence étant signée négativement ou positivement ;
  o une troisième étape préalable permettant de définir une première fréquence de résonance $fr_1$ asservie sur ladite différence d'amplitudes signées et répondant à l'équation suivante : $fr_1 = fr_0 + K*[\Delta(Pf_{1,1}-Pf_{2,1}) - Ca]$, avec Ca une consigne d'asservissement et K une constante ;

- une série d'étapes comportant :

  o l'interrogation dudit résonateur à une fréquence $f_{1,2k}$ dite inférieure de rang 2k dans la série (ou à une fréquence $f_{2,2k}$ dite supérieure de rang 2k dans la série) avec k entier supérieur à 1, successive à l'interrogation dudit résonateur à une fréquence $f_{2,2k-1}$ dite supérieure de rang 2k-1 dans la série (ou à une fréquence $f_{1,2k-1}$ dite inférieure de rang 2k-1 dans la série), telle que : $f_{1,2k} = fr_{2k-1} - f_m/2$ (ou $f_{2,2k} = fr_{2k-1} + f_m/2$), permettant de définir l'amplitude d'un signal de réception $Pf_{1,2k}$ (ou celle d'un signal $Pf_{2,2k}$) ;
  o la détermination de la différence des amplitudes des signaux : $\Delta(Pf_{1,2k} - Pf_{2,2k-1})$ [ou $\Delta(Pf_{1,2k-1} - Pf_{2,2k})$], ladite différence étant signée négativement ou positivement ;
  o la fréquence $fr_{2k}$ étant asservie sur la différence d'amplitude $\Delta(Pf_{1,2k} - Pf_{2,2k-1})$ [ou $\Delta(Pf_{1,2k-1} - Pf_{2,2k})$] selon l'équation suivante : $f_{r\,2k} = f_{r\,2k-1} + K[\Delta(Pf_{1,\,2k} - Pf_{2,\,2k-1}) - Ca]$ [ou $f_{r\,2k} = f_{r\,2k-1} + K[\Delta(Pf_{1,\,2k-1} - Pf_{2,\,2k}) - Ca]]$ ;

- l'étape suivante comportant :

  o l'interrogation dudit résonateur à une fréquence $f_{2,2k+1}$ dite supérieure de rang 2k+1 dans la série (ou à une fréquence $f_{1,\,2k+1}$ dite inférieure de rang 2k+1) dans la série avec k entier supérieur à 1, telle que :

$$f_{2,2k+1} = fr_{2k} + f_m/2 \ (ou \ f_{1,2k+1} = fr_{2k} - f_m/2),$$

permettant de définir l'amplitude d'un signal de réception $Pf_{2,2k+1}$ (ou celle d'un signal $Pf_{1,2k+1}$) ;
  o la détermination de la différence des amplitudes des signaux : $\Delta(Pf_{2,2k+1} - Pf_{1,2k})$ [ou $\Delta(Pf_{2,,2k} - Pf_{1,,2k+1})$], ladite différence étant signée négativement ou positivement ;
- la fréquence $fr_{2k+1}$ étant asservie sur la différence d'amplitude

  o $\Delta(Pf_{2,2k+1} - Pf_{1,2k})$ [ou $\Delta(Pf_{2,2k} - Pf_{1,2k,1})$] selon l'équation suivante :

$$f_{r\,2k+1} = f_{r\,2k} + K\,[\Delta\,(Pf_{2,\,2k+1} - Pf_{1,\,2k}) - Ca]$$

[ou $f_{r\,2k+1} = f_{r\,2k} + K\,[\Delta\,(Pf_{2,\,2k} - Pf_{1,\,2k+1}) - Ca]$]

de manière à obtenir une fréquence de résonance déterminée $fr_{2k+1}$ à partir d'une fréquence $fr_{2k}$ telle que la différence d'amplitudes signée : $\Delta(Pf_{2,2k+1} - Pf_{1,2k})$ [ou $\Delta\,(Pf_{2,2k} - Pf_{1,2k+1})$] est égale à la consigne d'asservissement Ca.

Selon une variante de l'invention, l'étape préalable de balayage en fréquence d'interrogation dudit résonateur dans une bande de fréquences permettant la détermination rapide d'une première fréquence de résonance $fr_0$ dudit résonateur est effectuée avec un pas de fréquences égal à environ le tiers de la large à mi-hauteur de la courbe de résonance.

Selon une variante de l'invention, la bande de fréquences est une bande ISM, et plus particulièrement celle centrée en 433,9 MHz.

Selon une variante de l'invention, la fréquence $f_m$ est inférieure à quelques dizaines de kilohertz.

Selon une variante de l'invention, la vitesse de rafraîchissement de l'interrogation est de l'ordre de quelques kilohertz et atteint la bande passante maximale accessible par un résonateur.

Selon une variante de l'invention, la vitesse de rafraîchissement de l'interrogation est de l'ordre de quelques kilohertz pour atteindre la fréquence maximale de rafraichissement accessible de 16,6 kHz par un transducteur à encombrement spectral réduit (résonateur) à 434 MHz pour un facteur de qualité de 10000.

Selon une variante de l'invention, la consigne d'asservissement est nulle.

Selon une variante de l'invention, la constante K est égale à 1.

L'invention a aussi pour objet un dispositif mettant en oeuvre le procédé d'interrogation selon l'invention, caractérisé en ce qu'il comprend :

- une source radiofréquence reconfigurable ;
- un microcontrôleur pour reconfigurer ladite source ;
- des moyens de réception et de traitement numérique de l'amplitude du signal de réception.

L'invention sera mieux comprise et d'autres avantages apparaîtront à la lecture de la description qui va suivre donnée à titre non limitatif et grâce aux figures parmi lesquelles :

- la figure 1 illustre le principe d'interrogation d'un capteur SAW selon l'art connu
- la figure 2 illustre deux évolutions possibles de la fonction de transfert à un instant donné et les deux conditions à un instant ultérieur à savoir l'atténuation du signal ou le décalage de la fréquence de résonance ;
- la figure 3 illustre l'étape préalable de balayage en fréquence permettant de déterminer les fréquences $f_{rpi}$ et $f_{rps}$ ;
- la figure 4 illustre un exemple de dispositif permettant de qualifier la bande passante de mesure d'un résonateur à ondes élastiques de surface ;
- la figure 5 illustre la mesure de la réponse d'un résonateur à ondes élastiques de surface dans le cadre du procédé d'interrogation de la présente invention.

Selon la présente invention, le procédé d'interrogation comprend ainsi une étape préalable de balayage en fréquence d'interrogation dudit résonateur dans une gamme de fréquences connue par la conception même du résonateur concerné et permettant la détermination rapide d'une première fréquence de résonance $fr_0$ dudit résonateur par détection de l'amplitude du signal de réponse dudit résonateur. Typiquement il pourra être intéressant pour de nombreuses applications de se positionner dans la bande ISM citée précédemment (ou une autre bande ISM compatible de l'utilisation des résonateurs radio-fréquences, en particulier ceux à ondes élastiques).

La figure 3 illustre une telle courbe sur laquelle on est en mesure de définir la fréquence de résonance préalable et les deux fréquences $fr_{pi}$ et $fr_{ps}$ permettant de déterminer la fréquence $f_m$ choisie inférieure à la différence : $fr_{ps} - fr_{ps}$

Il est à noter que le choix de l'écart des fréquences d'interrogation est effectué selon un compromis entre la puissance renvoyée et la précision de la mesure. En effet, plus ces fréquences sont éloignées de la fréquence de résonance, moins la puissance retournée par le capteur est importante, mais plus la mesure est précise.

La demanderesse a constaté que l'influence de la fréquence $f_m$ ne semble par affecter la résolution de la mesure lorsqu'elle est comprise entre 1 kHz et 50 kHz. Cependant, choisir une fréquence $f_m$ trop grande dégrade la portée de la mesure, le résonateur étant peu efficace loin de sa résonance. Typiquement on pourra choisir dans la bande ISM centrée en 433,9 MHz, une fréquence $f_m$ de l'ordre de 10kHz.

Le procédé d'interrogation de l'invention est alors effectué de la manière suivante :

Dans une première phase, on réalise un ensemble d'étapes préalables :

- dans une première préalable, on effectue l'interrogation à une première fréquence $f_{1,1}$ et à une deuxième fréquence $f_{2,1}$ telles que : $f_{1,1} = fr_0 - f_m/2$ et $f_{2,1} = fr_0 + f_m/2$, permettant de définir un premier couple d'amplitudes $Pf_{1,1}$ et $Pf_{2,1}$ d'un premier signal et d'un second signal de réception ;
- dans une seconde étape préalable, on procède à la détermination de la différence des amplitudes $\Delta (Pf_{1,1} - Pf_{2,1})$, ladite différence étant signée ;
- dans une troisième étape préalable, on définit une première fréquence de résonance $fr_1$ asservie sur ladite différence d'amplitudes signée et répondant à l'équation suivante :

$$fr_1 = fr_0 + K*[\Delta(Pf_{1,1} - Pf_{2,1}) - Ca],$$

avec Ca une consigne d'asservissement et K une constante.

Le procédé d'interrogation de la présente invention comprend alors les étapes successives :

- on peut calculer la fréquence $f_{2,2} = fr_1 + f_m / 2$ ;
- on sonde à cette fréquence : $f_{2,2} = fr_1 + f_m / 2$ pour obtenir la puissance $Pf_{2,2}$ à cette fréquence ;
- on détermine à nouveau une fréquence $fr_2$ en utilisant cette nouvelle puissance sondée $Pf_{2,2}$, corrélée à la puissance précédente sondée $Pf_{1,1}$

Ainsi de proche en proche on réitère la série d'étapes précédentes, corrélant une nouvelle interrogation à une interrogation précédente.

Il est à noter que dans la présente description, le procédé est décrit, dans l'hypothèse où l'on sonde à la fréquence $f_{2,2}$, un procédé identique pourrait tout aussi bien être appliqué dans le cas, d'un sondage réalisé à la fréquence $f_{1,2} = fr_1 - f_m / 2$ .

On sonde alors successivement et alternativement les fréquences $f_{1,2k+1}$ et les fréquences $f_{2,2k+2}$ permettant de mettre en oeuvre le procédé de la présente invention basé sur une succession d'une seule interrogation et non plus de deux comme dans le procédé décrit dans la demande de brevet FR 2 958 417.

Dans ces phases successives, on procède à la détermination des valeurs répertoriées dans le Tableau 1 ci-après, à titre illustratif dans lequel sont indiquées en gras les amplitudes sondées.

Tableau 1

| $f_{1,1}$ | $f_{2,1}$ | **$Pf_{1,1}$** | **$Pf_{2,1}$** | $fr_1 = fr_0 + K[\Delta(Pf_{1,1} - Pf_{2,1}) - Ca]$ |
|---|---|---|---|---|
| | $f_{2,2}$ | $Pf_{1,1}$ | **$Pf_{2,2}$** | $fr_2 = fr_1 + K[\Delta(Pf_{1,1} - Pf_{2,2}) - Ca]$ |
| $f_{1,3}$ | | **$Pf_{1,3}$** | $Pf_{2,2}$ | $fr_3 = fr_2 + K[\Delta(Pf_{1,3} - Pf_{2,2}) - Ca]$ |
| | $f_{2,4}$ | $Pf_{1,3}$ | **$Pf_{2,4}$** | $fr_4 = fr_3 + K[\Delta(Pf_{1,3} - Pf_{2,4}) - Ca]$ |
| | | | | |
| | $f_{2,2k}$ | $Pf_{1, 2k-1}$ | **$Pf_{2, 2k}$** | $fr_{2k} = fr_{2k-1} + K[\Delta(Pf_{1, 2k-1} - Pf_{2, 2k}) - Ca]$ |

avec k entier et :

$$f_{1,3} = fr_2 - f_m / 2$$

$$f_{2,4} = fr_3 + f_m / 2$$

$$f_{2,2k} = fr_{2k+1} + f_m / 2$$

On procède de la sorte, jusqu'à atteindre une valeur de fréquence de résonance $fr_{2k+2}$, telle que la différence des amplitudes signées :

$Pf_{1,2k-1} - Pf_{2,2k}$ soit égale à la valeur Ca.

Par exemple, la valeur Ca peut être choisie égale à 0.
Avec Ca égale à 0, le procédé d'itération est terminé lorsque la condition :

$$Pf_{1,2k-1} - Pf_{2,2k} = 0$$

De même en sondant à partir d'une première fréquence $f_{1,2}$, on peut élaborer le Tableau 2 ci-après :

| $f_{1,1}$ | $f_{2,1}$ | $Pf_{1,1}$ | $Pf_{2,1}$ | $fr_1 = fr_0 + K[\Delta(Pf_{1,1} - Pf_{2,1}) - Ca]$ |
|---|---|---|---|---|
| $f_{1,2}$ | | $\mathbf{Pf_{1,2}}$ | $Pf_{2,1}$ | $fr_2 = fr_1 + K[\Delta(Pf_{1,2} - Pf_{2,1}) - Ca]$ |
| | $f_{2,3}$ | $Pf_{1,2}$ | $\mathbf{Pf_{2,3}}$ | $fr_3 = fr_2 + K[\Delta(Pf_{1,3} - Pf_{2,3}) - Ca]$ |
| $f_{1,4}$ | | $\mathbf{Pf_{1,4}}$ | $Pf_{2,3}$ | $fr_4 = fr_3 + K[\Delta(Pf_{1,4} - Pf_{2,3}) - Ca]$ |
| ... | | ... | | ... |
| | $f_{2,2k}$ | $Pf_{1,2k-1}$ | $\mathbf{Pf_{2,2k}}$ | $fr_{2k} = fr_{2k-1} + K[\Delta(Pf_{1,2k} - Pf_{2,2k-1}) - Ca]$ |

Ainsi et selon l'invention, le signal reçu pour la première fréquence $f_{11} = fr_0 - f_m/2$ contient une information de puissance (ou amplitude) totale correspondant à une valeur moyenne et une contribution de modulation que l'on peut considérer comme « virtuelle » à basse fréquence. Le signal reçu à la seconde fréquence $f_{2,1} = fr_0 + f_m/2$ contient une information de puissance (ou amplitude) totale correspondant à une valeur moyenne et une contribution de modulation que l'on peut considérer comme « virtuelle » à haute fréquence.
La contribution de la valeur moyenne est éliminée lors du calcul de la différence des puissances reçues aux fréquences $f_{1,1}$ et $f_{2,1}$ afin d'extraire uniquement la contribution du signal de modulation. La différence des puissances reçues à chaque fréquence fournit une information dont le signe va dépendre de la position par rapport à la fréquence $fr_0$. Ainsi selon l'invention, il est proposé de réaliser une fonction itérative permettant d'annuler le résiduel mentionné ci-dessus. Cette étape peut être effectuée par une méthode de dichotomie, par une méthode de Newton ou toute autre méthode permettant l'accélération de la convergence du processus itératif.
Ainsi toute méthode capable de déterminer le zéro d'une fonction est particulièrement adaptable en l'occurrence : la méthode de dichotomie est une approche consistant à réduire l'intervalle de recherche d'un zéro de la fonction traitée par comparaison des signes de cette fonction après estimation. Les échantillons sont toujours pris de sorte que leur signe soit opposé. On divise l'intervalle en deux puis l'on identifie le nouvel intervalle pour lequel les nouveaux échantillons sont de signes opposés. On poursuit le processus jusqu'à respect du critère de convergence. La méthode de Newton quant à elle s'appuie sur l'exploitation de la série de Taylor au premier ordre au voisinage du zéro à identifier. A chaque nouvelle prise d'échantillon on calcule la dérivée première de la courbe pour l'échantillon le plus éloigné du zéro et l'on exploite la dérivée première pour déduire une estimation de celui-ci.
Le processus converge ou bout d'un nombre d'itérations d'autant plus faible que la courbe est régulière et monotone au voisinage du point recherché. Ces exemples sont fournis à titre d'illustration et peuvent être avantageusement remplacés par des méthodes plus efficaces (Müller, etc.). Une référence bibliographique utile en ce sens est : A. Angot, Compléments de mathématiques, Masson Ed., 6ème Edition, 1982, et à l'international Abramowitz and Stegun. Handbook of Mathematical Functions, on line http://www.math.ucla.edu/~cbm/aands/
On réalise ainsi un asservissement de la fréquence $fr_0$ qui coïncide avec la fréquence de résonance du capteur interrogé. Cet asservissement s'apparente à une boucle à verrouillage de phase dont les caractéristiques de stabilité et de précision dans la détection de la fréquence cible sont meilleures que les éléments de cette mesure en boucle ouverte.

Pour mettre en oeuvre le procédé d'interrogation de la présente invention, il est intéressant d'utiliser un interrogateur en configuration monostatique (avec partage entre l'émetteur et le récepteur de l'électronique et de l'antenne permettant de réduire l'encombrement et les coûts de synchronisation entre l'émetteur et le récepteur) pouvant être de type RADAR impulsionnel à balayage en fréquence. Cet interrogateur comprend un microcontrôleur chargé d'appliquer une boucle d'asservissement alternativement sur l'une des deux fréquences selon le processus décrit ci-après :

- on émet pendant par exemple 30 $\mu$s, soit 5 constantes de temps du résonateur, une impulsion radiofréquence à la fréquence souhaitée fr$_{2k}$;
- connaissant la mesure qui a été faite auparavant à une fréquence antérieure, f$_{r\,2k-1}$, on calcule fr$_{2k}$ = fr$_{2k-1}$ + K[$\Delta$(Pf$_{1,\,2k-1}$ - Pf$_{2,\,2k}$) -Ca] qui équilibrerait la réponse (correspondant à la puissance retournée par le transducteur SAW) aux fréquences fr$_{2k-1}$ et fr$_{2k}$ ;
- on fournit alors une tension (DAC) proportionnelle à cette estimation de la fréquence ainsi déterminée.

Typiquement, la fréquence f$_m$/2 peut être de quelques kilohertz, soit dans la gamme des applications visées, environ 1/8 de la largeur à mi-hauteur.

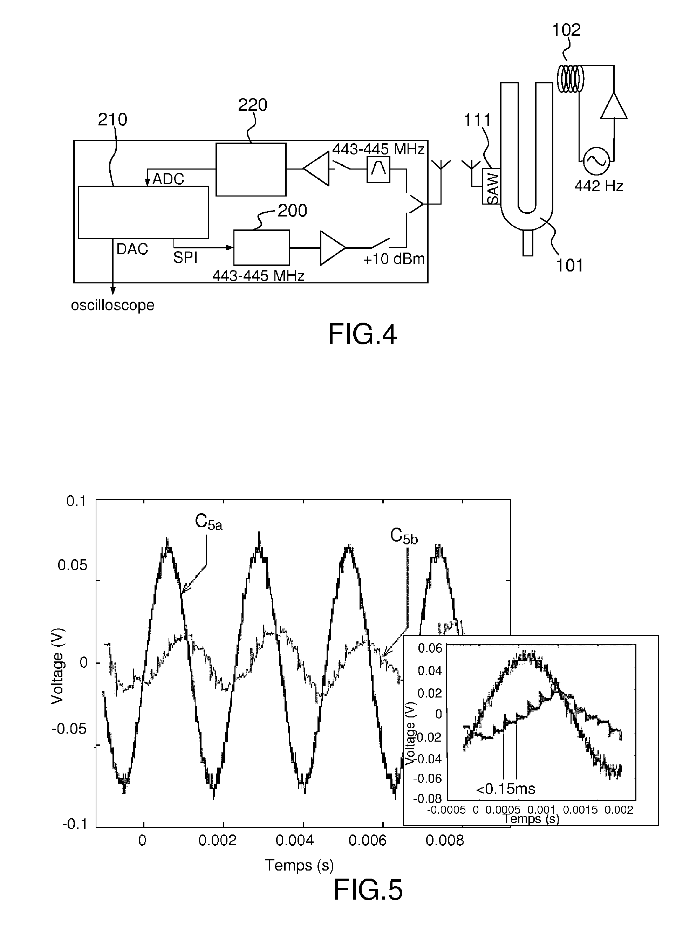

La figure 4 illustre un exemple de dispositif permettant de qualifier la bande passante de mesure du résonateur à ondes élastiques de surface. Il s'agit d'un dispositif expérimental permettant de qualifier la bande passante de mesure d'un résonateur 111 à ondes élastiques de surface SAW, fixé à la base du bras d'un diapason 101 excité par un électroaimant 102. La méthode des mesures de la fréquence de résonance du SAW exploite une source radiofréquence reconfigurable 200 (Direct Digital Synthesizer-DDS) configuré par un micro-contrôleur 210. La puissance renvoyée par le capteur SAW pour chaque fréquence sondée est détectée par un détecteur 220 et numérisée (ADC) pour traitement numérique du signal et définition de la prochaine fréquence f$_{1,\,2k}$ ou f$_{2,\,2k}$, à émettre afin de rester proche (sous ou sur respectivement) de la fréquence de résonance. Il s'agit d'un diapason musical (fréquence nominale de résonance de 440 Hz) équipé d'un résonateur à ondes élastiques de surface en quartz collé à la base d'un de ses bras. Ce résonateur se comporte comme une jauge de contrainte, dont la fréquence de résonance (autour de 434 MHz, dans la bande Industrielle, Scientifique et Médicale (ISM- européenne) varie avec la contrainte transmise du bras du diapason au substrat de quartz. Ainsi, le résonateur à quartz voit sa fréquence de résonance varier lors du mouvement du bras du diapason. Afin de faciliter la démarche expérimentale en observant un régime stationnaire, le diapason musical est excité par induction magnétique par un électroaimant alimenté par un signal sinusoïdal généré par un synthétiseur de fréquence dont la fréquence est proche de la fréquence de résonance du diapason (442 Hz).

Le résultat de cette mesure est illustré en figure 5, indiquant un rafraîchissement de l'information transmise à l'utilisateur, de 6800 Hz. Compte-tenu d'un temps de charge du résonateur de 30 $\mu$s et d'un temps de décharge de durée égale (constante de temps de Q/$\pi$ périodes du résonateur, avec Q facteur de qualité), sonder la réponse à une fréquence nécessite 60 $\mu$s soit un taux de rafraîchissement maximal de 16, 6 KHz.

La courbe C$_{5a}$ est relative à l'excitation du diapason proche de la fréquence de résonance du résonateur, la courbe C$_{5b}$ étant relative à la mesure de la réponse du résonateur. Le zoom illustre la fréquence de rafraîchissement de l'information de 6800 Hz dans cette implémentation de l'algorithme.

Une telle implémentation expérimentale sur microcontrôleur nécessite par ailleurs :

- la reconfiguration expérimentale de la source de fréquence nécessaire à générer le signal sonde radiofréquence à f$_{1,2k-1}$ puis f$_{2,\,2k}$ ;
- le stockage en mémoire des mesures et leur traitement numérique ;
- la programmation d'un convertisseur numérique-analogique pour retranscrire une tension proportionnelle à la fréquence de résonance déduite du calcul.

Ces opérations expliquent une fréquence de rafraîchissement de l'ordre du tiers de la fréquence maximale accessible. Une implémentation sur architecture numérique dédiée (ASIC, FPGA) permettant d'atteindre la bande passante maximale par réduction de la durée de traitement numérique du signal.

Ainsi, selon le procédé de la présente invention, l'exploitation de la valeur antérieure de la puissance renvoyée par le capteur combinée avec la nouvelle mesure de puissance selon les lois explicitées précédemment, alternant ainsi mesure et rafraîchissement de la grandeur mesurée et fournie à l'utilisateur, permet de doubler la vitesse de mesure par rapport au procédé objet de la demande de brevet FR 2 958 417.

**Revendications**

1. Procédé d'interrogation à distance d'un résonateur à ondes élastiques, permettant de déterminer la fréquence de résonance dudit résonateur présentant une courbe de résonance définie par conception dudit résonateur, **caractérisé en ce qu'**il comporte les étapes suivantes :

   - une étape préalable de balayage en fréquence d'interrogation dudit résonateur dans une gamme de fréquences déterminée par conception dudit résonateur, permettant la détermination rapide d'une courbe de résonance centrée sur une fréquence de résonance préalable $fr_0$ comprise entre une fréquence préalable inférieure $fr_{pi}$ et une fréquence préalable supérieure $fr_{ps}$ définies à mi-hauteur de ladite courbe de résonance dudit résonateur, par détection de l'amplitude de signal de réponse dudit résonateur ;
   - un premier ensemble d'étapes préalables comportant :

      o une première étape préalable d'un premier couple d'interrogations dudit résonateur à une première fréquence $f_{1,1}$ dite inférieure et à une deuxième fréquence $f_{2,1}$ dite supérieure telles que : $f_{1,1} = fr_0 - f_m/2$ et $f_{2,1} = fr_0 + f_m/2$, avec $f_m < fr_{ps} - fr_{pi}$, permettant de définir un premier couple d'amplitudes d'un premier signal et d'un second signal de réception $Pf_{1,1}$ et $Pf_{2,1}$ ;
      o une seconde étape préalable comportant la détermination de la différence des amplitudes des premier et second signaux $\Delta(Pf_{1,1}-Pf_{2,1})$, ladite différence étant signée négativement ou positivement ;
      o une troisième étape préalable permettant de définir une première fréquence de résonance $fr_1$ asservie sur ladite différence d'amplitudes signées et répondant à l'équation suivante : $fr_1 = fr_0 + K^*[\Delta(Pf_{1,1}-Pf_{2,1}) - Ca]$, avec Ca une consigne d'asservissement et K une constante ;

   - une série d'étapes comportant :

      o l'interrogation dudit résonateur à une fréquence $f_{1,2k}$ dite inférieure de rang 2k dans la série (ou à une fréquence $f_{2,2k}$ dite supérieure de rang 2k dans la série) avec k entier supérieur à 1, successive à l'interrogation dudit résonateur à une fréquence $f_{2,2k-1}$ dite supérieure de rang 2k-1 dans la série (ou à une fréquence $f_{1,2k-1}$ dite inférieure de rang 2k-1 dans la série), telle que : $f_{1,2k} = fr_{2k-1} - f_m/2$ (ou $f_{2,2k} = fr_{2k-1} + f_m/2$), permettant de définir l'amplitude d'un signal de réception $Pf_{1,2k}$ (ou celle d'un signal $Pf_{2,2k}$) ;
      o la détermination de la différence des amplitudes des signaux : $\Delta(Pf_{1,2k} - Pf_{2,2k-1})$ [ou $\Delta(Pf_{1,2k-1} - Pf_{2,2k})$], ladite différence étant signée négativement ou positivement ;
      o la fréquence $fr_{2k}$ étant asservie sur la différence d'amplitude $\Delta(Pf_{1,2k} - Pf_{2,2k-1})$ [ou $\Delta(Pf_{1,2k-1} - Pf_{2,2k})$] selon l'équation suivante : $f_{r\,2k} = f_{r\,2k-1} + K[\Delta(Pf_{1,2k} - Pf_{2,2k-1}) - Ca]$ [ou $f_{r\,2k} = f_{r\,2k-1} + K[\Delta(Pf_{1,2k-1} - Pf_{2,2k}) - Ca]]$ ;

   - l'étape suivante comportant :

      o l'interrogation dudit résonateur à une fréquence $f_{2,2k+1}$ dite supérieure de rang 2k+1 dans la série (ou à une fréquence $f_{1,2k+1}$ dite inférieure de rang 2k+1) dans la série avec k entier supérieur à 1, telle que :

$$f_{2,2k+1} = fr_{2k} + f_m/2 \text{ (ou } f_{1,2k+1} = fr_{2k} - f_m/2),$$

   permettant de définir l'amplitude d'un signal de réception $Pf_{2,2k+1}$ (ou celle d'un signal $Pf_{1,2k+1}$) ;
      o la détermination de la différence des amplitudes des signaux : $\Delta(Pf_{2,2k+1} - Pf_{1,2k})$ [ou $\Delta(Pf_{2,2k} - Pf_{1,2k+1})$], ladite différence étant signée négativement ou positivement ;

   - la fréquence $fr_{2k+1}$ étant asservie sur la différence d'amplitude

      o $\Delta(Pf_{2,2k+1} - Pf_{1,2k})$ [ou $\Delta(Pf_{2,2k} - Pf_{1,2k+1})$] selon l'équation suivante :

$$f_{r\,2k+1} = f_{r\,2k} + K[\Delta(Pf_{2,\,2k+1} - Pf_{1,\,2k}) - Ca]$$

   [ou $f_{r\,2k+1} = f_{r\,2k} + K[\Delta(Pf_{2,\,2k} - Pf_{1,\,2k+1}) - Ca]]$

de manière à obtenir une fréquence de résonance déterminée $fr_{2k+1}$ à partir d'une fréquence $fr_{2k}$ telle que la différence d'amplitudes signée : $\Delta(Pf_{2,2k+1} - Pf_{1,2k})$ [ou $\Delta (Pf_{2,2k} - Pf_{1,2k+1})$] est égale à la consigne d'asservissement Ca.

2. Procédé d'interrogation d'un résonateur selon la revendication 1, **caractérisé en ce que** l'étape préalable de balayage en fréquence d'interrogation dudit résonateur dans une bande de fréquences permettant la détermination rapide d'une première fréquence de résonance ($fr_0$) dudit résonateur est effectuée avec un pas de fréquences égal à environ le tiers de la large à mi-hauteur de la courbe de résonance .

3. Procédé d'interrogation d'un résonateur selon l'une des revendications 1 ou 2, **caractérisé en ce que** la bande de fréquences est une bande ISM, et plus particulièrement celle centrée en 433,9 MHz.

4. Procédé d'interrogation d'un résonateur selon l'une des revendications 1 à 3, **caractérisé en ce que** la fréquence $f_m$ est inférieure à quelques dizaines de kilohertz.

5. Procédé d'interrogation d'un résonateur selon l'une des revendications 1 à 4, **caractérisé en ce que** la vitesse de rafraîchissement de l'interrogation est de l'ordre de quelques kilohertz et atteint la bande passante maximale accessible par un résonateur.

6. Procédé d'interrogation d'un résonateur selon l'une des revendications 1 à 5, **caractérisé en ce que** la consigne d'asservissement est nulle.

7. Procédé d'interrogation d'un résonateur selon l'une des revendications 1 à 6, **caractérisé en ce que** la constante K est égale à 1.

8. Dispositif mettant en oeuvre le procédé d'interrogation selon l'une des revendications 1 à 7, **caractérisé en ce qu'**il comprend :

   - une source radiofréquence reconfigurable ;
   - un microcontrôleur pour reconfigurer ladite source ;
   - des moyens de réception et de traitement numérique de l'amplitude du signal de réception

FIG.1

FIG.2

FIG.3

FIG.4

FIG.5

**EP 2 873 952 A2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2958417

**Littérature non-brevet citée dans la description**

- **J.M FRIEDT ; C. DROIT ; S. BALLANDRAS ; S. ALZUAGA ; G. MARTIN ; P. SANDOZ.** Remote vibration measurement: a wireless passive surface acoustic wave resonator fast probing strategy. *Rev. Sci. Instrum.,* vol. 83, 055001

- Compléments de mathématiques. **A. ANGOT.** Handbook of Mathematical Functions. 1982